# EUROPEAN PATENT SPECIFICATION

(11) **EP 3 439 024 B1**
(45) Date of publication and mention of the grant of the patent: **24.04.2024**
(21) Application number: 17774499.2
(22) Date of filing: 21.03.2017
(51) Int. Cl.: H01L 21/304, H01L 21/683, C09J 7/29, C09J 7/30

(54) **ADHESIVE FILM FOR PROCESSING SEMICONDUCTOR WAFER**
KLEBEFOLIE FÜR DIE VERARBEITUNG VON HALBLEITERWAFERN
FILM ADHÉSIF POUR LE TRAITEMENT D'UNE TRANCHE DE SEMI-CONDUCTEUR

(30) Priority: 31.03.2016 JP 2016070945
(43) Date of publication of application: 06.02.2019
(73) Proprietor: Mitsui Chemicals Tohcello, Inc., Tokyo 101-8485 (JP)
(72) Inventor: KURIHARA, Hiroyoshi, Nagoya-shi Aichi 457-0801 (JP); FUKUMOTO, Hideki, Nagoya-shi Aichi 457-0801 (JP)
(74) Representative: Hoffmann Eitle
(86) International application number: PCT/JP2017/011134
(87) International publication number: WO 2017/169958

(56) References cited:
- EP-A1- 2 500 390
- WO-A1-2015/132852
- JP-A- 2003 105 292
- JP-A- 2007 070 491
- JP-A- 2009 260 332
- JP-A- 2010 163 587
- JP-A- 2010 177 542
- JP-A- 2011 210 944
- JP-A- 2014 024 206
- JP-A- 2015 119 106
- US-A1- 2011 014 443

## Description

### TECHNICAL FIELD

The present invention relates to an adhesive film for processing a semiconductor wafer and the use of the adhesive film.

### BACKGROUND ART

Among steps for manufacturing a semiconductor device, in a step of polishing or cutting a semiconductor wafer, an adhesive film is attached to the semiconductor wafer in order to fix the semiconductor wafer or prevent damage of the semiconductor wafer.

As the above-described adhesive film, generally, a film obtained by laminating an ultraviolet-curable adhesive resin layer on a base material film is used. When this adhesive film is irradiated with ultraviolet rays, the adhesive resin layer cross-links, and the adhesive force of the adhesive resin layer decreases, and thus the adhesive film can be easily peeled off from the semiconductor wafer.

Meanwhile, in steps for manufacturing a semiconductor device using the above-described adhesive film, there have been cases in which static electricity called peeling charging is generated during the peeling of the adhesive film from the semiconductor wafer. There have been cases in which a circuit formed on the semiconductor wafer is broken due to the static electricity generated as described above (electrostatic breakdown) or a foreign substance such as dust is attached to a circuit formed on the semiconductor wafer.

Particularly, in response to an increase in the density of semiconductor wafers and a decrease in wire pitches in recent years, there has been a tendency that semiconductor wafers are likely to be affected by static electricity more than ever.

In consideration of the above-described circumstance, recently, for adhesive films used to prevent the fixation or damage of semiconductor wafers in steps for manufacturing a semiconductor device, there has been a demand for the additional improvement in antistatic performance.

As a technique regarding an adhesive film for processing a semiconductor wafer as described above, for example, the technique described in Patent Document 1 (Japanese Unexamined Patent Publication No. 2011-210944) is exemplified.

Patent Document 1 describes an adhesive tape for processing an antistatic semiconductor which is an adhesive tape constituted of a base material film and a photocurable adhesive layer and includes an antistatic layer containing a conductive polymer in at least one surface of the base material film and an adhesive layer containing a photocurable unsaturated carbon bond in a molecule of a base polymer on the antistatic layer, in which a surface resistivity on the adhesive layer side before and after ultraviolet curing is 1 × 10⁶ to 5 × 10¹² Ω/□, a thickness of the adhesive layer is 20 to 250 um, and a 90-degree peel adhesive force (based on JIS Z 0237: a peel rate is 50 mm/min) after the ultraviolet curing of the adhesive layer in a case in which the adhesive tape is attached to a silicon mirror wafer is 0.15 to 0.25 N/25 mm.

Furthermore, JP 2009-260332 A describes an adhesive tape for fixing a semiconductor wafer. The adhesive tape is formed with an antistatic layer having conductivity on one side of a substrate and an adhesive layer which is further formed on the antistatic layer. The adhesive layer consists essentially of an adhesive hardened by ultraviolet rays and further includes a conductive material. The antistatic layer includes conductive polymers, such as a π-electron conjugated polymer.

JP 2003-105292 A is concerned with an antistatic dicing tape. The tape has a photocrosslinkable antistatic adhesive layer on one side of a substrate film, which comprises a (meth)acrylate oligomer having a polyalkylene oxide chain the termination of which is converted to an alkoxide.

EP 2 500 390 A1 relates to a pressure-sensitive adhesive tape for temporary fixing of electronic parts. The adhesive tape includes at least a supporting substrate film and a thermally expandable pressure-sensitive adhesive layer provided on one side of the substrate. The thermally expandable pressure-sensitive adhesive layer contains thermally expandable microspheres and an ionic liquid. The content of the ionic liquid is 0.01 to 10 parts by weight based on 100 parts by weight of a polymer contained in the thermally expandable pressure-sensitive adhesive layer. The surface resistance of the thermally expandable pressure-sensitive adhesive layer is 1.0 × 10¹³ Ω/□ or less, and the ratio of the surface resistance after heating for foaming to that before the heating is 5.0 or less. According to an embodiment, the adhesive tape may contain an elastic layer provided between the substrate film and the adhesive layer.

US 2011/014443 A1 relates to an adhesive tape for electronic component fabrication, which comprises a base material film and an adhesive layer. An antistatic layer, which is comprised of an electrically conductive polymer, is formed on one side or both sides of the base material film. The adhesive layer is a radiation curable type, which has a copolymer of an acrylic system as a principal ingredient, each containing at least a radiation curable carbon-carbon double bond containing group, a hydroxyl group and a carbonyl group, that are individually attached to a principal chain.

### RELATED DOCUMENT

### PATENT DOCUMENT

[Patent Document 1] Japanese Unexamined Patent Publication No. 2011-210944

### SUMMARY OF THE INVENTION

### TECHNICAL PROBLEM

As described above in the section of the background art, recently, a technical level demanded regarding a viewpoint of a static electricity countermeasure for an adhesive film for processing a semiconductor wafer has been gradually rising.

The present inventors found a problem as described below regarding the adhesive film for processing a semiconductor wafer of the related art as described in Patent Document 1.

First, the present inventors found that the adhesive film described in Patent Document 1 has a problem in that, when the adhesive film is peeled off from a semiconductor wafer, an adhesive component of the adhesive film is likely to remain on a circuit-formed surface of the semiconductor wafer, that is, an adhesive deposit is likely to be generated, and the contamination resistance on the semiconductor wafer surface is poor.

Furthermore, according to the present inventors' studies, it has been clarified that, in the adhesive film described in Patent Document 1, when the degree of crosslinking of the adhesive layer is increased by increasing the amount of ultraviolet rays radiated in order to suppress the generation of the adhesive deposit, the generation of the adhesive deposit is suppressed, and thus the contamination resistance on the semiconductor wafer surface is improved, but an antistatic property deteriorates.

That is, according to the present inventors' studies, it has been clarified that, in the adhesive film for processing a semiconductor wafer of the related art, there is a trade-off relationship between the contamination resistance on the semiconductor wafer surface and the antistatic property. That is, the present inventors found that, for the adhesive film for processing a semiconductor wafer of the related art, there is room for improvement from the viewpoint of improving the contamination resistance on the semiconductor wafer surface and the antistatic property in a well-balanced manner.

The present invention has been made in consideration of the above-described circumstance and provides an adhesive film for processing a semiconductor wafer which is excellent in terms of the balance between the adhesiveness and the contamination resistance on the semiconductor wafer surface, is capable of suppressing the amount of static electricity being generated when the adhesive film is peeled off from the semiconductor wafer, and enables the stable obtainment of a semiconductor component having an excellent quality.

### SOLUTION TO PROBLEM

The present inventors repeated intensive studies in order to achieve the above-described object. As a result, it was found that, in an adhesive film including a base material layer and an ultraviolet-curable adhesive resin layer provided on one surface side of the base material layer, an index of a saturated electrostatic potential of the adhesive resin layer photocured by a large amount of ultraviolet rays is effective as a design guide for satisfying both the contamination resistance on the semiconductor wafer surface and the antistatic property.

In addition, as a result of additional intensive studies on the basis of the above-described finding, the present inventors found that, when the saturated electrostatic potential of the adhesive resin layer photocured by a large amount of ultraviolet rays is set to equal to or less than a specific value, it is possible to improve the above-described trade-off relationship and improve the contamination resistance on the semiconductor wafer surface and the antistatic property in a well-balanced manner and completed the present invention.

According to the present invention, an adhesive film for processing a semiconductor wafer and the use of the adhesive film as defined in the appended claims are provided. The adhesive film is described below.

According to the present invention an adhesive film for processing a semiconductor wafer and for protecting a surface of a semiconductor wafer or fixing the semiconductor wafer includes: a base material layer and an ultraviolet-curable adhesive resin layer provided on one surface side of the base material layer,
in which the adhesive resin layer includes an ultraviolet-curable adhesive resin, and
a saturated electrostatic potential V₁ of the adhesive resin layer surface after ultraviolet curing, which is measured using a method described below, is equal to or less than 2.0 kV.

### (Method)

Ultraviolet rays having a main wavelength of 365 nm are radiated to the adhesive resin layer using a high-pressure mercury lamp in an environment of 25°C at a radiation intensity of 100 mW/cm² and an ultraviolet amount of 1,080 mJ/cm², thereby photocuring the adhesive resin layer. Next, a voltage is applied to a surface of the adhesive resin layer for 30 seconds under conditions of an applied voltage of 10 kV, a distance between a specimen and electrodes of 20 mm, 25°C, and 50%RH, and the saturated electrostatic potential (V₁) of the surface of the adhesive resin layer is computed according to JIS L1094.

The adhesive resin layer has an antistatic layer and an adhesive layer in this order from the base material layer side. The adhesive resin layer further has an unevenness-absorbing resin layer between the base material layer and the antistatic layer. A thickness of the adhesive layer is less than 30 um. The ultraviolet-curable adhesive resin includes a (meth)acrylic adhesive resin having a photopolymerizable carbon-carbon double bond in a molecule. The resin constituting the unevenness-absorbing resin layer includes one, two or more selected from the group consisting of olefin-based resins, ethylene·polar monomer copolymers, ABS resins, vinyl chloride resins, vinylidene chloride resins, (meth)acrylic resins, polyamide resins, and fluorine-based resins.

The present invention further relates to the use of the adhesive film as a back grinding tape for processing a semiconductor wafer.

### ADVANTAGEOUS EFFECTS OF INVENTION

According to the present invention, it is possible to provide an adhesive film for processing a semiconductor wafer which is excellent in terms of the balance between the adhesiveness and the contamination resistance on the semiconductor wafer surface, is capable of suppressing the amount of static electricity being generated when the adhesive film is peeled off from the semiconductor wafer, and enables the stable obtainment of a semiconductor component having an excellent quality.

### BRIEF DESCRIPTION OF THE DRAWINGS

The above-described object and other objects, characteristics, and advantages will be further clarified using a preferred embodiment described below and the accompanying drawings below.

FIG. 1 is a cross-sectional view schematically showing a reference example of a structure of an adhesive film for processing a semiconductor wafer.
FIG. 2 is a cross-sectional view schematically showing a reference example of the structure of an adhesive film for processing a semiconductor wafer.
FIG. 3 is a cross-sectional view schematically showing an example of the structure of the adhesive film for processing a semiconductor wafer of the embodiment according to the present invention.

### DESCRIPTION OF EMBODIMENTS

Hereinafter, an embodiment of the present invention will be described using drawings. Meanwhile, in all of the drawings, similar constituent elements will be given a common reference sign and will not be repeated. In addition, the drawings are schematic views, and dimensional ratios do not match actual dimensional ratios. Meanwhile, unless particularly otherwise described, a numerical range "A to B" indicates equal to and more than A and equal to and less than B. In addition, in the present embodiment, " (meth) acryl" refers to acryl, methacryl, or both acryl and methacryl.

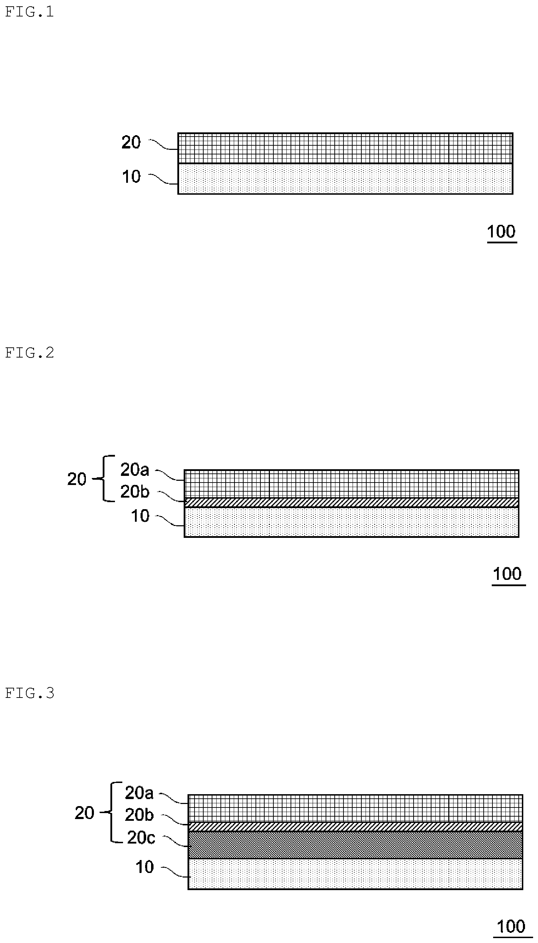

FIGS. 1 to 3 are cross-sectional views schematically showing examples of a structure of an adhesive film for processing a semiconductor wafer 100. FIGS. 1 and 2 relate to reference examples. FIG. 3 shows an example of a structure of an adhesive film for processing a semiconductor wafer 100 according to the present invention.

As shown in FIG. 1, an adhesive film for processing a semiconductor wafer 100 (hereinafter, also referred to as "the adhesive film 100") includes a base material layer 10 and an ultraviolet-curable adhesive resin layer 20 provided on one surface side of the base material layer 10 and is used to protect a surface of a semiconductor wafer or fix the semiconductor wafer. In addition, in the adhesive film 100, the adhesive resin layer 20 includes an ultraviolet-curable adhesive resin, and a saturated electrostatic potential V₁ of the adhesive resin layer 20 after ultraviolet curing, which is measured using a method described below, is equal to or less than 2.0 kV.

### (Method)

Ultraviolet rays having a main wavelength of 365 nm are radiated to the adhesive resin layer 20 using a high-pressure mercury lamp in an environment of 25°C at a radiation intensity of 100 mW/cm² and an ultraviolet amount of 1,080 mJ/cm², thereby photocuring the adhesive resin layer 20. Next, a voltage is applied to a surface of the adhesive resin layer 20 for 30 seconds under conditions of an applied voltage of 10 kV, a distance between a specimen and electrodes of 20 mm, 25°C, and 50%RH, and the saturated electrostatic potential (V₁) of the surface of the adhesive resin layer 20 is computed according to JIS L1094.

As described above, recently, the technical level demanded regarding a viewpoint of a static electricity countermeasure for an adhesive film for processing a semiconductor wafer has been gradually rising. Particularly, in the case of using a semiconductor wafer having bump electrodes such as solder bumps or copper pillar bumps formed on a high-density circuit of a semiconductor wafer on which a high-density circuit is disposed, there has been a tendency that the breakage (short) of the circuit including the bump electrodes formed on the semiconductor wafer is likely to occur due to static electricity, and thus the above-described demand has been further intensifying.

Therefore, there has been a demand for realizing an adhesive film for processing a semiconductor wafer having a more favorable antistatic property.

Here, the present inventors found a problem as described below regarding the adhesive film for processing a semiconductor wafer of the related art as described in Patent Document 1.

First, the present inventors found that the adhesive film described in Patent Document 1 has a problem in that, when the adhesive film is peeled off from the semiconductor wafer, an adhesive component of the adhesive film is likely to remain on the circuit-formed surface of the semiconductor wafer, that is, an adhesive deposit is likely to be generated, and the contamination resistance on the semiconductor wafer surface is poor.

Furthermore, according to the present inventors' studies, it has been clarified that, in the adhesive film described in Patent Document 1, when the degree of crosslinking of an adhesive layer is increased by increasing the amount of ultraviolet rays radiated in order to suppress the generation of the adhesive deposit, the generation of the adhesive deposit is suppressed, and thus the contamination resistance on the semiconductor wafer surface is improved, but the antistatic property deteriorates.

That is, according to the present inventors' studies, it has been clarified that, in the adhesive film for processing a semiconductor wafer of the related art, there is a trade-off relationship between the contamination resistance on the semiconductor wafer surface and the antistatic property. That is, the present inventors found that, for the adhesive film for processing a semiconductor wafer of the related art, there is room for improvement from the viewpoint of improving the contamination resistance on the semiconductor wafer surface and the antistatic property in a well-balanced manner.

The present inventors carried out intensive studies on the basis of the above-described finding regarding the adhesive film for processing a semiconductor wafer of the related art in order to realize an adhesive film for processing a semiconductor wafer which is capable of improving the contamination resistance on the semiconductor wafer surface and the antistatic property in a well-balanced manner. As a result, it was found that the saturated electrostatic potential V₁ of the adhesive resin layer 20 after ultraviolet curing, which is measured using the above-described method, is effective as a design guide for satisfying both the contamination resistance on the semiconductor wafer surface and the antistatic property.

In addition, as a result of additional intensive studies on the basis of the above-described finding, the present inventors found for the first time that, when the saturated electrostatic potential V₁ of the adhesive resin layer 20 after ultraviolet curing is set to equal to or less than 2.0 kV, it is possible to improve the above-described trade-off relationship and improve the contamination resistance on the semiconductor wafer surface and the antistatic property in a well-balanced manner.

That is, when the adhesive film for processing a semiconductor wafer 100 is provided with the above-described layer constitution, the balance between the adhesiveness and the contamination resistance on the semiconductor wafer surface is excellent, the amount of static electricity being generated when the adhesive film is peeled off from the semiconductor wafer can be suppressed, and a semiconductor component having an excellent quality can be stably obtained.

In the adhesive film 100, the saturated electrostatic potential V₁ of the adhesive resin layer 20 after ultraviolet curing is equal to or less than 2.0 kV, preferably equal to or less than 1.5 kV, more preferably equal to or less than 1.0 kV, and particularly preferably equal to or less than 0.5 kV. When the saturated electrostatic potential V₁ of the adhesive resin layer 20 after ultraviolet curing is set to equal to or less than the above-described upper limit value, it is possible to further improve the balance between the contamination resistance on the semiconductor wafer surface and the antistatic property.

The lower limit value of the saturated electrostatic potential V₁ of the adhesive resin layer surface 20 after ultraviolet curing is, for example, equal to or more than 0.01 kV and preferably 0 kV.

It is possible to control the saturated electrostatic potential V₁ of the adhesive resin layer surface 20 after ultraviolet curing by appropriately adjusting, for example, the kinds or blending proportions of individual components constituting the adhesive resin layer 20 and the layer constitution of the adhesive resin layer 20.

Among these, for example, the content of an ionic additive in the adhesive resin layer 20, the presence or absence of an antistatic layer 20b in the adhesive resin layer 20, the location of the antistatic layer 20b, and the thickness of an adhesive layer 20a are exemplified as elements for setting the saturated electrostatic potential V₁ of the adhesive resin layer 20 after ultraviolet curing in a desired numerical range.

For example, when the content of the ionic additive in the adhesive resin layer 20 is increased or the antistatic layer 20b is provided, it is possible to decrease the saturated electrostatic potential V₁. According to the present invention, an antistatic layer is provided.

In addition, since an unevenness-absorbing resin layer 20c is provided in the adhesive resin layer 20, and the thickness of the adhesive layer 20a is decreased, it is possible to decrease the distance between an adhesive surface (that is, the surface of the adhesive resin layer) to the semiconductor wafer and the antistatic layer 20b, and consequently, the saturated electrostatic potential V₁ can be effectively decreased.

In the adhesive film 100, when the saturated electrostatic potential of the surface of the adhesive resin layer 20 after ultraviolet curing, which is measured using a method described below, is represented by V₂, V₁V₂ is preferably equal to or less than 5.0, more preferably equal to or less than 3.0, and still more preferably equal to or less than 2.5. When V_{1/}V₂ is equal to or less than the upper limit value, it is possible to more stably suppress the amount of static electricity being generated when the adhesive film is peeled off from the semiconductor wafer, and a semiconductor component having a more favorable quality can be stably obtained.

### (Method)

Ultraviolet rays having a main wavelength of 365 nm are radiated to the adhesive resin layer 20 using a high-pressure mercury lamp in an environment of 25°C at a radiation intensity of 100 mW/cm² and an ultraviolet amount of 200 mJ/cm², thereby photocuring the adhesive resin layer 20. Next, a voltage is applied to the surface of the adhesive resin layer 20 for 30 seconds under conditions of an applied voltage of 10 kV, a distance between a specimen and electrodes of 20 mm, 25°C, and 50%RH, and the saturated electrostatic potential (V₂) of the surface of the adhesive resin layer 20 is computed according to JIS L1094.

In the adhesive film 100, the half-life of the saturated electrostatic potential V₁ of the adhesive resin layer 20 is preferably equal to or shorter than 100 seconds, more preferably equal to or shorter than 50 seconds, still more preferably equal to or shorter than 30 seconds, far still more preferably equal to or shorter than 10 seconds, and particularly preferably equal to or shorter than 1 second.

Here, the half-life of the saturated electrostatic potential V₁ refers to a period of time taken for the value of the electrostatic potential to decrease to half from the end of the application of the voltage to the surface of the adhesive resin layer 20 in the measurement of the saturated electrostatic potential V₁.

In the adhesive film 100, the saturated electrostatic potential V₁ of the adhesive resin layer 20 after ultraviolet curing is equal to or less than the above-described upper limit value, and thus it is possible to realize a short half-time as described above and produce the adhesive film 100 having an excellent antistatic property.

In the adhesive film 100, the tack force of the surface of the adhesive resin layer 20 after ultraviolet curing, which is measured using a method described below, is preferably equal to or less than 0.1 N/cm², more preferably equal to or less than 0.05 N/cm², and still more preferably equal to or less than 0.01 N/cm².

When the tack force of the surface of the adhesive resin layer 20 after ultraviolet curing is equal to or less than the above-described upper limit value, it becomes easier to peel the adhesive film 100 off from the semiconductor wafer surface, and it is possible to further suppress the remaining of a part of the adhesive resin layer 20 on the semiconductor wafer surface and the generation of disadvantages in the semiconductor wafer due to the peeling of the adhesive film 100.

### (Method)

Ultraviolet rays having a main wavelength of 365 nm are radiated to the adhesive resin layer 20 using a high-pressure mercury lamp in an environment of 25°C at a radiation intensity of 100 mW/cm² and an ultraviolet amount of 1,080 mJ/cm², thereby photocuring the adhesive resin layer 20. Next, the tack force of the surface of the adhesive resin layer 20 is measured using a method in which, using a probe tack tester (for example, "a probe tack tester manufactured by TESTING MACHINES Inc.: model 80-02-01") as a measurement instrument, a probe having a diameter of 5 mm and the surface of the adhesive resin layer 20 are brought into contact with each other at a rate of 10 mm/second and held in contact with each other at a contact load of 0.98 N/cm² for 10 seconds, and then the probe is peeled off from the surface of the adhesive resin layer 20 in the vertical direction at a rate of 10 mm/second.

The thickness of the entire adhesive film 100 is preferably equal to or more than 20 um and equal to or less than 1,000 um and more preferably equal to or more than 50 um and equal to or less than 500 um in terms of the balance between the mechanical characteristics and the handleability.

The adhesive film 100 is used to protect the surface of the semiconductor wafer or fix the semiconductor wafer in steps for manufacturing a semiconductor device and, more specifically, preferably used as a back grinding tape that is used to protect the circuit-formed surface (that is, a circuit surface including a circuit pattern) of the semiconductor wafer in the back grind step which is one of the steps for manufacturing a semiconductor device.

Here, in a case in which the semiconductor wafer that is an attachment subject is a semiconductor wafer having bump electrodes such as solder bumps or copper pillar bumps formed on the surface, for example, electrostatic breakage which is the breakage of a circuit formed on the semiconductor wafer due to static electricity being generated when the adhesive film is peeled off from the semiconductor wafer is likely to occur, but the use of the adhesive film 100 enables more reliable suppression of the electrostatic breakdown in a semiconductor wafer having bump electrodes formed on the surface as described above.

Semiconductor wafers to which the adhesive film 100 can be applied are not particularly limited, and examples thereof include silicon wafers.

Next, the respective layers constituting the adhesive film for processing a semiconductor wafer 100 will be described.

### <Base Material Layer>

The base material layer 10 is a layer provided for the purpose of further improving the characteristics such as handleability, mechanical characteristics, and heat resistance of the adhesive film 100.

The base material layer 10 is not particularly limited as long as the base material layer has a mechanical strength high enough to withstand an external force being applied during the processing of the semiconductor wafer, and examples thereof include a resin film.

As a resin constituting the resin film, a well-known thermoplastic resin can be used. Examples thereof include one or more resins selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as nylon-6, nylon-66, and polymethaxylene adipamide; polyacrylate; polymethacrylate; polyvinyl chloride; polyimide; polyether imide; ethylene-vinyl acetate copolymers; polyacrylonitrile; polycarbonate; polystyrene; ionomers; polysulfone; polyethersulfone; and polyphenylene ether.

Among these, from the viewpoint of improving the transparency, one or more selected from polypropylene, polyethylene terephthalate, polyethylene naphthalate, polyamide, polyimide, and ethylene-vinyl acetate copolymers are preferred, and one or more selected from polyethylene terephthalate and polyethylene naphthalate are more preferred.

The base material layer 10 may be a single layer or two or more kinds of layers.

In addition, the form of the resin film being used to form the base material layer 10 may be a stretched film or may be a film stretched in a monoaxial direction or a biaxial direction, but is preferably a film stretched in a monoaxial direction or a biaxial direction from the viewpoint of improving the mechanical strength of the base material layer 10.

The thickness of the base material layer 10 is preferably equal to or more than 10 um and equal to or less than 500 µm, more preferably equal to or more than 20 um and equal to or less than 300 µm, and still more preferably equal to or more than 25 um and equal to or less than 150 um from the viewpoint of obtaining favorable film characteristics.

In order to improve the adhesiveness to other layers, a surface treatment may be carried out on the base material layer 10. Specifically, a corona treatment, a plasma treatment, an undercoat treatment, or a primer coat treatment may, for example, be carried out.

The total light transmittance of the base material layer 10 is preferably equal to or more than 85% and more preferably equal to or more than 90% . In such a case, it is possible to impart transparency to the base material layer 10. In addition, when the total light transmittance of the base material layer 10 is set to equal to or more than the above-described lower limit value, it is possible to more effectively radiate ultraviolet rays to the adhesive resin layer 20 by radiating ultraviolet rays from the base material layer 10 side in the adhesive film 100, and the ultraviolet radiation efficiency can be improved. Meanwhile, the total light transmittance of the base material layer 10 can be measured according to JIS K7105 (1981) .

### <Adhesive Resin Layer>

The adhesive resin layer 20 is a layer provided on one surface side of the base material layer 10 and a layer that is adhered to a surface of the semiconductor wafer when the adhesive film for processing a semiconductor wafer 100 is attached to the semiconductor wafer.

The adhesive resin layer 20 includes the adhesive layer 20a including an ultraviolet-curable adhesive resin as an essential component.

In addition, the adhesive resin layer 20 further includes the antistatic layer 20b and the unevenness-absorbing resin layer 20c which will be described below.

In the adhesive film 100, the thickness of the adhesive resin layer 20 is generally equal to or more than 5 um and equal to or less than 550 µm, preferably equal to or more than 10 um and equal to or less than 400 µm, more preferably equal to or more than 30 um and equal to or less than 300 µm, and particularly preferably equal to or more than 50 um and equal to or less than 250 um. When the thickness of the adhesive resin layer 20 is in the above-described range, the balance between the adhesiveness to the semiconductor wafer surface and the handleability is favorable.

### (Adhesive Layer)

The adhesive layer 20a is a layer formed of an ultraviolet-curable adhesive including an ultraviolet-curable adhesive resin as an essential component.

Examples of the ultraviolet-curable adhesive include a (meth)acrylic adhesive, a silicone-based adhesive, and an urethane-based adhesive.

The (meth) acrylic adhesive includes, as the ultraviolet-curable adhesive resin, a (meth)acrylic adhesive resin as an essential component. The silicone-based adhesive includes, as the ultraviolet-curable adhesive resin, a silicone-based adhesive resin as an essential component. The urethane-based adhesive includes, as the ultraviolet-curable adhesive resin, an urethane-based adhesive resin as an essential component.

Among these, the (meth)acrylic adhesive is preferred from the viewpoint of facilitating the adjustment of the adhesive force, and included in the ultraviolet-curable adhesive resin according to the present invention.

As the (meth)acrylic adhesive, adhesives which include a (meth)acrylic adhesive resin having a photopolymerizable carbon-carbon double bond in the molecule, a low-molecular-weight compound having two or more photopolymerizable carbon-carbon double bonds in the molecule, and a photoinitiator and are obtained by cross-linking the (meth)acrylic adhesive resin using a crosslinking agent as necessary can be exemplified.

Specifically, the (meth)acrylic adhesive resin having a photopolymerizable carbon-carbon double bond in the molecule can be obtained as described below. First, a monomer having an ethylenic double bond and a copolymerizable monomer having a functional group (P) are copolymerized together. Next, the functional group (P) included in this copolymer and a monomer having a functional group (Q) capable of causing, for example, an addition reaction or a condensation reaction with the functional group (P) are reacted together while the double bond is left in the monomer, thereby introducing the photopolymerizable carbon-carbon double bond into the copolymer molecule.

As the monomer having an ethylenic double bond, for example, one or more from monomers having an ethylenic double bond such as acrylic acid alkyl ester and methacrylic acid alkyl ester monomers such as methyl (meth) acrylate, 2-ethylhexyl (meth)acrylate, butyl (meth) acrylate, and ethyl (meth) acrylate, vinyl esters such as vinyl acetate, and monomers having an ethylenic double bond such as (meth)acrylonitrile, (meth)acrylamide, and styrene are used.

As the copolymerizable monomer having a functional group (P), (meth)acrylic acid, maleic acid, 2-hydroxyethyl (meth)acrylate, glycidyl (meth)acrylate, N-methylol (meth)acrylamide, and (meth)acryloyloxyethyl isocyanate are exemplified. These copolymerizable monomers may be used singly or two or more copolymerizable monomers may be used in combination. The proportions of the monomer having an ethylenic double bond and the copolymerizable monomer having a functional group (P) are preferably 70% to 99% by mass for the former monomer and 30% to 1% by mass for the latter monomer. The proportions are more preferably 80% to 95% by mass for the former monomer and 20% to 5% by mass for the latter monomer.

As the monomer having a functional group (Q), for example, the same monomers as the copolymerizable monomer having a functional group (P) can be exemplified.

The combination of the functional group (P) and the functional group (Q) which are reacted together when the photopolymerizable carbon-carbon double bond is introduced into the copolymer of the monomer having an ethylenic double bond and the copolymerizable monomer having a functional group (P) is desirably a combination that easily causes an addition reaction such as a carboxyl group and an epoxy group, a carboxyl group and an aziridyl group, or a hydroxyl group and an isocyanate group. Alternatively, the reaction is not limited to the addition reaction, and any reactions such as a condensation reaction between a carboxylic acid group and a hydroxyl group may also be used as long as the photopolymerizable carbon-carbon double bond can be easily introduced.

As the low-molecular-weight compound having two or more photopolymerizable carbon-carbon double bonds in the molecule, tripropylene glycol di (meth)acrylate, trimethylolpropane tri(meth)acrylate, tetramethylolmethane tetraacrylate, pentaerythritol tetra(meth)acrylate, dipentaerythritol monohydroxypenta (meth)acrylate, and dipentaerythritol hexa(meth)acrylate are exemplified. These compounds may be used singly or two or more compounds may be jointly used. The amount of the low-molecular-weight compound having two or more photopolymerizable carbon-carbon double bonds in the molecule added is preferably 0.1 to 20 parts by mass and more preferably 5 to 18 parts by mass with respect to 100 parts by mass of the (meth) acrylic adhesive resin.

As the photoinitiator, benzoin, isopropyl benzoin ether, isobutyl benzoin ether, benzophenone, Michler's ketone, chlorothioxanthone, dodecyl thioxanthone, dimethyl thioxanthone, diethyl thioxanthone, acetophenone diethyl ketal, benzyl dimethyl ketal, 1-hydroxy cyclohexyl phenyl ketone, and 2-hydroxy-2-methyl-1-phenylpropan-1-one are exemplified. These photoinitiators may be used singly or two or more photoinitiators may be jointly used. The amount of the photoinitiator added is preferably 0.1 to 15 parts by mass and more preferably 5 to 10 parts by mass with respect to 100 parts by mass of the (meth) acrylic adhesive resin.

To the ultraviolet-curable adhesive, a crosslinking agent may be added. As the crosslinking agent, epoxy-based compounds such as sorbitol polyglycidyl ether, polyglycerol polyglycidyl ether, pentaerythritol polyglycidyl ether and diglycerol polyglycidyl ether, aziridine-based compounds such as tetramethylolmethane-tri-β-aziridinyl propionate, trimethylolpropane-tri-β-aziridinyl propionate, N,N'-diphenylmethane-4,4'-bis(1-aziridinecarboxamide), and N,N'-hexamethylene-1,6-bis(1-aziridinecarboxamide), isocyanate-based compounds such as tetramethylene diisocyanate, hexamethylene diisocyanate, and polyisocyanate are exemplified. The ultraviolet-curable adhesive may, for example, be any of a solvent-type adhesive, an emulsion-type adhesive, and a hot melt-type adhesive.

The content of the crosslinking agent is, generally, preferably in a range in which the number of functional groups in the crosslinking agent does not exceed the number of functional groups in the (meth) acrylic adhesive resin. However, in a case in which functional groups are newly generated in a crosslinking reaction or a case in which the crosslinking reaction is slow, the ultraviolet-curable adhesive may excessively contain the crosslinking agent as necessary.

The content of the crosslinking agent in the (meth)acrylic adhesive resin is preferably equal to or more than 0.1 parts by mass and equal to or less than 15 parts by mass with respect to 100 parts by mass of the (meth)acrylic adhesive resin from the viewpoint of improving the balance with the heat resistance or adhesiveness of the adhesive resin layer 20.

The ultraviolet-curable preferably further includes an ionic additive in addition to the ultraviolet-curable adhesive resin. In such a case, it is possible to improve the antistatic property of the adhesive resin layer 20.

Examples of the ionic additive include a cationic surfactant, an anionic surfactant, a non-ionic surfactant, an amphoteric surfactant, and an ion liquid. From the viewpoint of further improving the antistatic property of the adhesive resin layer 20, at least one selected from a cationic surfactant and an anionic surfactant is preferred, and a cationic surfactant is more preferred.

Examples of the cationic surfactant include dodecyl trimethyl ammonium chloride, tetradecyl dimethyl benzyl ammonium chloride, cetyl dimethyl benzyl ammonium chloride, stearyl dimethyl benzyl ammonium chloride, tetradecyl trimethyl ammonium chloride, hexadecyl trimethyl ammonium chloride, octadecyl trimethyl ammonium chloride, didodecyl dimethyl ammonium chloride, ditetradecyl dimethyl ammonium chloride, dihexadecyl dimethyl ammonium chloride, dioctadecyl dimethyl ammonium chloride, dodecyl benzyl dimethyl ammonium chloride, tetradecyl benzyl dimethyl ammonium chloride, hexadecyl benzyl dimethyl ammonium chloride, octadecyl benzyl dimethyl ammonium chloride, palmityl trimethyl ammonium chloride, oleyl trimethyl ammonium chloride, dipalmityl benzyl methyl ammonium chloride, and dioleyl benzyl methyl ammonium chloride.

As the cationic surfactant, quaternary ammonium salts or amine salt-type surfactants can be exemplified, and quaternary ammonium salts are preferred.

Among these, tetradecyl dimethyl benzyl ammonium chloride, cetyl dimethyl benzyl ammonium chloride, and stearyl dimethyl benzyl ammonium chloride are preferred.

Examples of the anionic surfactant include alkyl diphenyl ether disulfonates such as diammonium dodecyl diphenyl ether disulfonate, sodium dodecyl diphenyl ether disulfonate, calcium dodecyl diphenyl ether disulfonate, and sodium alkyl diphenyl ether disulfonate; alkylbenzenesulfonic acid salts such as sodium dodecylbenzenesulfonate and ammonium dodecylbenzenesulfonate; alkylsulfuric acid ester salts such as sodium lauryl sulfate and ammonium lauryl sulfate; aliphatic carboxylic acid salts such as sodium aliphatic acid and potassium oleate; polyoxyalkylene unit-containing sulfuric acid ester salts (for example, polyoxyethylene alkyl ether sulfuric acid ester salts such as sodium polyoxyethylene alkyl ether sulfate and ammonium polyoxyethylene alkyl ether sulfate; polyoxyethylene alkyl phenyl ether sulfuric acid ester salts such as sodium polyoxyethylene alkyl phenyl ether sulfate and ammonium polyoxyethylene alkyl phenyl ether sulfate; polyoxyethylene polycyclic phenyl ether sulfate salts such as sodium polyoxyethylene polycyclic phenyl ether sulfate, and ammonium polyoxyethylene polycyclic phenyl ether sulfate); naphthalenesulfonic acid formalin condensate salts such as sodium naphthalenesulfonate formalin condensate; alkyl sulfosuccinates such as sodium dialkyl sulfosuccinate and disodium monoalkyl sulfosuccinate; polyoxyethylene-polyoxypropylene glycol ether sulfate; and surfactants having a sulfonic acid salt or a sulfuric acid ester group and a polymerizable carbon-carbon (unsaturated) double bond.

Examples of the non-ionic surfactant include polyoxyalkylene unit-containing ether compounds such as polyoxyalkylene alkyl ether compounds such as polyoxyethylene lauryl ether, polyoxyethylene stearyl ether, polyoxyethylene tridecyl ether, and polyoxyethylene oleyl ether, polyoxyalkylene alkyl phenyl ether compounds such as polyoxyethylene octyl phenyl ether and polyoxyethylene nonyl phenyl ether, and polyoxyalkylene polycyclic phenyl ether compounds such as polyoxyethylene polycyclic phenyl ether; polyoxyalkylene alkyl ester compounds such as polyoxyethylene monolaurate, polyoxyethylene monostearate, and polyoxyethylene monooleate; polyoxyalkylene alkylamine compounds such as polyoxyethylene alkylamine; and sorbitan compounds such as sorbitan monolaurate, sorbitan monostearate, sorbitan trioleate, polyoxyethylene sorbitan monolaurate, and polyoxyethylene sorbitan monooleate.

As the amphoteric surfactant, lauryl betaine and lauryl dimethyl amine oxide are exemplified.

These ionic additives may be used singly or two or more ionic additives may be used in combination.

The content of the ionic additive in the ultraviolet-curable adhesive resin is preferably equal to or more than 0.01 parts by mass and equal to or less than 10 parts by mass and more preferably equal to or more than 0.1 parts by mass and equal to or less than 5 parts by mass with respect to 100 parts by mass of the ultraviolet-curable adhesive resin.

The adhesive layer 20a can be formed by, for example, applying an adhesive coating fluid onto a different layer such as the base material layer 10, the antistatic layer 20b, or the unevenness-absorbing resin layer 20c.

As a method for applying the adhesive coating fluid, a well-known application method of the related art, for example, a roll coater method, a reverse roll coater method, a gravure roll method, a bar coat method, a comma coater method, or a die coater method can be employed. The conditions for drying the applied adhesive are not particularly limited; however, generally, the adhesive is preferably dried in a temperature range of 80°C to 200°C for 10 seconds to 10 minutes. More preferably, the adhesive is dried at 80°C to 170°C for 15 seconds to 5 minutes. In order to sufficiently accelerate a crosslinking reaction between the crosslinking agent and the (meth)acrylic adhesive resin, the adhesive coating fluid may be heated at 40°C to 80°C for approximately 5 to 300 hours after the end of the application of the adhesive coating fluid.

In the adhesive film 100, the thickness of the adhesive layer 20a is less than 30 µm, preferably equal to or less than 25 µm, and particularly preferably equal to or less than 20 um. In such a case, it is possible to decrease the distance between the surface of the adhesive resin layer 20 and the antistatic layer 20b, and consequently, the antistatic property of the adhesive film 100 can be further improved.

The lower limit value of the thickness of the adhesive layer 20a is not particularly limited, but is preferably equal to or more than 0.5 um, more preferably equal to or more than 1.0 um, still more preferably equal to or more than 3.0 um, and particularly preferably equal to or more than 5.0 um from the viewpoint of improving the adhesive force.

### (Antistatic Layer)

The adhesive resin layer 20 further includes the antistatic layer 20b. In such a case, it is possible to improve the antistatic property of the adhesive resin layer 20 and further suppress the amount of static electricity being generated when the adhesive film 100 is peeled off from the semiconductor wafer.

In the adhesive film for processing a semiconductor wafer 100, in a case in which the adhesive resin layer 20 further includes the antistatic layer 20b, the adhesive resin layer has the antistatic layer 20b and the adhesive layer 20a in this order from the base material layer 10 side as shown in FIG. 2. In such a case, it is possible to further suppress the amount of static electricity being generated during the peeling of the adhesive film while maintaining the adhesiveness of the adhesive film 100.

A material forming the antistatic layer 20b preferably includes a conductive polymer from the viewpoint of suppressing the generation of static electricity attributed to peeling by decreasing the surface resistance value of the antistatic layer 20b.

Examples of the conductive polymer include polythiophene-based conductive polymers, polypyrrole-based conductive polymers, polyaniline-based conductive polymers, poly(p-phenylene vinylene)-based polymers, and polyquinoxaline-based conductive polymers.

From the viewpoint of a favorable balance among the optical characteristics or the appearance, the antistatic property, the coatability, and the stability, polythiophene-based conductive polymers are preferred. Examples of the polythiophene-based conductive polymers include polyethylene dioxythiophene and polythiophene.

These conductive polymers may be used singly or two or more conductive polymers may be used in combination.

A material forming the antistatic layer 20b may further include, for example, a doping agent or a binder resin.

The doping agent is an agent that functions as a dopant and more reliably imparts a conductive property (dopes) to the conductive polymer, and examples thereof include sulfonic acid-based compounds.

Examples of the sulfonic acid-based compounds include p-toluenesulfonic acid, benzenesulfonic acid, ethylbenzenesulfonic acid, octylbenzenesulfonic acid, dodecylbenzenesulfonic acid, mesitylenesulfonic acid, m-xylene sulfonic acid, polystyrenesulfonic acid, and polyvinylsulfonic acid. From the viewpoint of improving the solubility or water dispersibility of the conductive polymer, polystyrenesulfonic acid or polyvinylsulfonic acid is preferred.

The sulfonic acid-based compound may be used singly or two or more sulfonic acid-based compounds may be used in combination.

When the doping agent is added to the material forming the antistatic layer as described above, the conductive polymer and the sulfonic acid compound partially react with each other so as to form a sulfonate, and, due to the action of this sulfonate, the antistatic function of the antistatic layer 20b further improves.

The blending proportion of the doping agent is, for example, 100 to 300 parts by mass with respect to 100 parts by mass of the conductive polymer.

As the combination of the conductive polymer and the doping agent, a combination of polyethylenedioxythiophene (PEDOT) and polystyrene sulfonic acid (PSS) is preferred since the antistatic property is more favorable.

A material forming the antistatic layer 20b may further include a binder resin from the viewpoint of improving the film-forming property or the adhesiveness.

Examples of the binder resin include polyurethane-based resins, polyester-based resins, (meth) acrylic resins, polyether-based resins, cellulose-based resins, polyvinyl alcohol-based resins, epoxy resins, polyvinyl pyrrolidone, polystyrene-based resins, polyethylene glycol, and pentaerythritol.

The binder resin may be used singly or two or more binder resins may be used in combination. The content of the binder resin is 10 to 500 parts by mass with respect to 100 parts by mass of the conductive polymer.

The thickness of the antistatic layer 20b is preferably equal to or more than 0.01 um and equal to or less than 10 µm, more preferably equal to or more than 0.01 um and equal to or less than 5 µm, and still more preferably equal to or more than 0.01 um and equal to or less than 1 um from the viewpoint of the antistatic performance.

### (Unevenness-Absorbing Resin Layer)

The adhesive resin layer 20 further includes the unevenness-absorbing resin layer 20c.

The unevenness-absorbing property of the entire adhesive film 100 improves, the adhesive resin layer follows the unevenness (including bumps) of the unevenness-formed surface (for example, the circuit-formed surface (that is, a circuit surface including a circuit pattern) of the semiconductor wafer, and it is possible to improve the adhesiveness between the circuit-formed surface of the semiconductor wafer and the adhesive film 100. Furthermore, it is possible to suppress the cracking of electrodes formed on the surface of the semiconductor wafer by an external force being applied during the processing of the semiconductor wafer.

In the adhesive film 100, in which the adhesive resin layer 20 further includes the antistatic layer 20b and the unevenness-absorbing resin layer 20c, the adhesive resin layer 20 is provided with a constitution in which the unevenness-absorbing resin layer 20c is provided between the base material layer 10 and the antistatic layer 20b as shown in FIG. 3.

Hence, it is possible to decrease the thickness of the adhesive layer 20a while improving the unevenness-absorbing property of the adhesive film 100, and thus the distance between the surface of the adhesive resin layer 20 and the antistatic layer 20b can be decreased, and consequently, it is possible to further improve the antistatic property of the adhesive film 100.

The density of the unevenness-absorbing resin layer 20c is preferably 800 to 990 kg/m³, more preferably 830 to 980 kg/m³, and still more preferably 850 to 970 kg/m³ from the viewpoint of the balance between the mechanical strength and the unevenness followability.

A resin constituting the unevenness-absorbing resin layer 20c includes one, two or more selected from olefin-based resins, ethylene·polar monomer copolymers, ABS resins, vinyl chloride resins, vinylidene chloride resins, (meth)acrylic resins, polyamide resins, fluorine-based resins, polycarbonate-based resins, and polyester-based resins.

Among these, olefin-based resins and ethylene·polar monomer copolymers are preferred.

Examples of the olefin-based resins include linear low-density polyethylene (LLDPE), low-density polyethylene, high-density polyethylene, polypropylene, ethylene·α-olefin copolymers including ethylene and an α-olefin having 3 to 12 carbon atoms, propylene·α-olefin copolymers including propylene and an α-olefin having 4 to 12 carbon atoms, ethylene·cyclic olefin copolymers, and ethylene·α-olefin·cyclic olefin copolymers.

Examples of the ethylene·polar monomer copolymers include ethylene·unsaturated carboxylic acid ester copolymers such as ethylene·ethyl (meth)acrylate copolymers, ethylene·methyl (meth)acrylate copolymers, ethylene·propyl (meth)acrylate copolymers, and ethylene·butyl (meth)acrylate copolymers; and ethylene·vinyl ester copolymers such as ethylene·vinyl acetate copolymers, ethylene·vinyl propionate copolymers, ethylene·vinyl butyrate copolymers, and ethylene·vinyl stearate copolymers.

The resin constituting the unevenness-absorbing resin layer 20c may be used singly or two or more resins may be blended together and used.

Examples of the α-olefin having 3 to 12 carbon atoms in the ethylene·α-olefin copolymers include propylene, 1-butene, 1-pentene, 3-methyl-1-butene, 1-hexene, 4-methyl-1-pentene, 3-methyl-1-pentene, 1-heptene, 1-octene, 1-decene, and 1-dodecene, and propylene and 1-butene are preferred.

Among these, due to the excellent unevenness followability during attachment, low-density polyethylene; polypropylene; ethylene·propylene copolymers, ethylene·1-butene copolymers, ethylene·α-olefin copolymers such as three-membered copolymers of ethylene, propylene, and an α-olefin having 4 to 12 carbon atoms; three-membered copolymers of propylene, 1-butene, and an α-olefin having 5 to 12 carbon atoms; and ethylene·vinyl acetate copolymers are preferred, and ethylene·propylene copolymers and ethylene·vinyl acetate copolymers are more preferred.

The thickness of the unevenness-absorbing resin layer 20c is not particularly limited as long as it is possible to fill unevenness on an unevenness-formed surface of the semiconductor wafer; however, for example, is preferably equal to or more than 10 um and equal to or less than 500 µm, more preferably equal to or more than 20 um and equal to or less than 400 µm, still more preferably equal to or more than 30 um and equal to or less than 300 µm, and particularly preferably equal to or more than 50 um and equal to or less than 250 µm.

In the adhesive film 100, an adhesive layer (not shown) may be provided between the respective layers. According to this adhesive layer, it is possible to improve the adhesive property between the respective layers.

In addition, on the adhesive film 100, a mold-release film may be further laminated.

Next, a method for manufacturing the adhesive film for processing a semiconductor wafer 100 will be described.

A method for manufacturing the adhesive film for processing a semiconductor wafer 100 is different from a manufacturing method of the related art, and it is necessary to strictly control manufacturing conditions. That is, it is possible to obtain the adhesive film 100 in which the above-described saturated electrostatic potential V₁ of the adhesive resin layer 20 after ultraviolet curing satisfies the above described specific conditions for the first time by using a manufacturing method in which a variety of factors relating to the following two conditions are strictly controlled.
(1) The kinds or blending proportions of the respective components constituting the adhesive resin layer 20
(2) The layer constitution of the adhesive resin layer 20

Examples of a specific constitution of the adhesive film 100 in which the above-described saturated electrostatic potential V₁ of the adhesive resin layer 20 after ultraviolet curing satisfies the above-described specific conditions include Example 1 to Example 3 described below.

(Example 1) The adhesive film 100 in which the adhesive resin layer 20 has the adhesive layer 20a containing the ionic additive and the unevenness-absorbing resin layer 20c, but does not have the antistatic layer 20b. Thus, Example 1 is for reference and not according to the claimed invention.

In the case of Example 1, the thickness of the adhesive layer 20a is preferably equal to or more than 5.0 um and equal to or less than 50 um and, from the viewpoint of further improving the antistatic property of the adhesive film 100, more preferably equal to or more than 5.0 um and less than 30 um. In addition, in the case of Example 1, the content of the ionic additive in the ultraviolet-curable adhesive resin is preferably equal to or more than 0.1 parts by mass and equal to or less than 5 parts by mass with respect to 100 parts by mass of the ultraviolet-curable adhesive resin.

(Example 2) The adhesive film 100 in which the adhesive resin layer 20 has the adhesive layer 20a not containing the ionic additive, the antistatic layer 20b, and the unevenness-absorbing resin layer 20c.

In the case of Example 2, the thickness of the adhesive layer 20a is preferably equal to or more than 5.0 um and less than 30 um. In such a case, it is possible to decrease the distance between the surface of the adhesive resin layer 20 and the antistatic layer 20b, and consequently, the antistatic property of the adhesive film 100 can be further improved.

(Example 3) The adhesive film 100 according to the present embodiment in which the adhesive resin layer 20 has the adhesive layer 20a containing the ionic additive, the antistatic layer 20b, and the unevenness-absorbing resin layer 20c.

In the case of Example 3, the thickness of the adhesive layer 20a is preferably equal to or more than 5.0 um and equal to or less than 50 um and, from the viewpoint of further improving the antistatic property of the adhesive film 100, more preferably equal to or more than 5.0 um and less than 30 um. In addition, in the case of Example 3, the content of the ionic additive in the ultraviolet-curable adhesive resin is preferably equal to or more than 0.1 parts by mass and equal to or less than 5 parts by mass with respect to 100 parts by mass of the ultraviolet-curable adhesive resin.

In addition, in a case in which the distance between the surface of the adhesive resin layer 20 and the antistatic layer 20b is relatively large, it is preferably to blend the ionic additive to both the adhesive layer 20a and the unevenness-absorbing resin layer 20c. Meanwhile, even in a case in which the thickness of the adhesive layer 20a is as thin as less than 30 um, the ionic additive may be blended into both the adhesive layer 20a and the unevenness-absorbing resin layer 20c.

However, for the adhesive film 100, it is possible to employ a variety of specific manufacturing conditions such as the temperature setting of a manufacturing apparatus under the premise that a variety of factors relating to the above-described two conditions are strictly controlled. In other words, the adhesive film 100 embodiment can be produced by employing any well-known method as long as a variety of factors relating to the above-described two conditions are strictly controlled. Hereinafter, an example of the method for manufacturing the adhesive film 100 will be described under the premise that a variety of factors relating to the above-described two conditions are strictly controlled.

First, the unevenness-absorbing resin layer 20c is formed on one surface of the base material layer 10 using an extrusion lamination method. Next, a predetermined conductive material is applied and dried on a separately-prepared mold-release film, thereby forming the antistatic layer 20b, and this antistatic layer 20b is laminated on the unevenness-absorbing resin layer 20c. Next, the adhesive coating fluid is applied and dried on the antistatic layer 20b, thereby forming the adhesive layer 20a and thus obtaining the adhesive film 100.

In addition, the base material layer 10 and the unevenness-absorbing resin layer 20c may be formed by co-extrusion molding or the film-like base material layer 10 and the film-like unevenness-absorbing resin layer 20c may be formed by lamination.

Next, an example of a method for polishing a rear surface of the semiconductor wafer(also referred to as back grind) using the adhesive film for processing a semiconductor wafer 100 will be described. In the method for polishing the rear surface of the semiconductor wafer, in the polishing of the rear surface of the semiconductor wafer, the adhesive film for processing a semiconductor wafer 100 is used as a back grinding tape.

First, the mold-release film is peeled off from the adhesive resin layer 20 of the adhesive film 100, the surface of the adhesive resin layer 20 is exposed, and the circuit-formed surface of the semiconductor wafer is attached onto this adhesive resin layer 20. Next, the semiconductor wafer is fixed to, for example, a chuck table of a polishing machine through the base material layer 10 of the adhesive film 100, and the rear surface (non-circuit-formed surface) of the semiconductor wafer is polished. After the end of the polishing, the adhesive film 100 is peeled off. There are cases in which a chemical etching step is carried out after the completion of the polishing of the rear surface of the semiconductor wafer and before the peeling of the adhesive film 100. In addition, a treatment such as water washing or plasma washing is carried out on the semiconductor wafer surface as necessary after the peeling of the adhesive film 100.

In the above-described rear surface-polishing operation, the semiconductor wafer is polished to, generally, approximately 100 to 600 um depending on the kind of a semiconductor chip from a thickness before polishing of, generally, 500 to 1,000 um. There are cases in which the semiconductor wafer is polished to be thinner than 100 um as necessary. The thickness of the semiconductor wafer before polishing is appropriately determined depending on, for example, the diameter or kind of the semiconductor wafer, and the thickness of the wafer after polishing is appropriately determined depending on, for example, the size of a chip to be obtained or the kind of a circuit.

An operation of attaching the semiconductor wafer to the adhesive film 100 is carried out manually in some cases; however, generally, the operation can be carried out using an apparatus called an automatic attachment device in which a roll-shaped adhesive film is mounted.

As a rear surface-polishing method, a well-known polishing method such as a through feed method or an infeed method is employed. In each of the polishing methods, the rear surface is polished while being cooled by applying water to the semiconductor wafer and a grind stone.

After the end of rear surface polishing, chemical etching is carried out as necessary. The chemical etching is carried out using a method in which the semiconductor wafer to which the adhesive film 100 is adhered is immersed in an etching fluid selected from the group consisting of acidic aqueous solutions made of hydrofluoric acid, nitric acid, sulfuric acid, acetic acid, and a liquid mixture thereof and alkaline aqueous solutions such as a potassium hydroxide aqueous solution and a sodium hydroxide aqueous solution. The etching is carried out for the purpose of, for example, the removal of distortion generated on the semiconductor wafer rear surface, the additional thinning of the wafer, the removal of, for example, an oxidized film , and a pretreatment during the formation of electrodes on the rear surface. The etching fluid is appropriately selected depending on the above-described purpose.

After the end of the rear surface polishing and the chemical etching, the adhesive film 100 is peeled off from the semiconductor wafer surface. A series of these operations are carried out manually in some cases; however, generally, the operations are carried out using an apparatus called an automatic peeling machine.

The semiconductor wafer surface from which the adhesive film 100 has been peeled off is washed as necessary. As a washing method, wet-type washing such as water washing or solvent washing, and dry-type washing such as plasma washing are exemplified. In the case of the wet-type washing, ultrasonic washing may be jointly used. These washing methods are appropriately selected depending on the contamination status of the semiconductor wafer surface.

### [Examples]

Hereinafter, the present invention will be specifically described using examples, but the present invention is not limited thereto.

The details of materials used to produce an adhesive film are as described below.

### <Base Material Layer>

Polyethylene terephthalate film (thickness: 50 µm)

### <Resin for Forming Unevenness-Absorbing Resin Layer>

Unevenness-absorbing resin layer 1: An ethylene·vinyl acetate copolymer (density: 960 kg/m³, "EVAFLEX EV150" manufactured by Du Pont Mitsui Polychemicals Co., Ltd.)

### <Material for Forming Antistatic Layer>

Material for forming an antistatic layer 1: A conductive material including polyethylenedioxythiophene/polystyrene sulfonic acid (PEDOT/PSS) (manufactured by Nagase ChemteX Corporation, trade name: DENATRON P-504CT)

### <Ionic Additive>

Ionic additive 1: Tetradecyl dimethyl benzyl ammonium chloride (manufactured by NOF Corporation, trade name: NISSAN CATION M₂-100)

### <Photoinitiator>

Photoinitiator 1: Benzyl dimethyl ketal (manufactured by BASF, trade name: IRGACURE 651)

### <Coating Fluid for Adhesive Layer 1>

n-Butyl acrylate (77 parts by mass), methyl methacrylate (16 parts by mass), 2-hydroxyethyl acrylate (16 parts by mass), and benzoyl peroxide (0.5 parts by mass) as a polymerization initiator were mixed together. The mixture was added dropwise to a nitrogen-substituted flask filled with toluene (20 parts by mass) and ethyl acetate (80 parts by mass) under stirring at 85°C for five hours, and, furthermore, the components were stirred for five hours and thus reacted. After the end of the reaction, this solution was cooled, toluene (10 parts by mass), methacryloyloxyethyl isocyante (manufactured by Showa Denko K.K., trade name: KARENZ MOI) (7 parts by mass), and dibutyltin dilaurate (0.02 parts by mass) were added to the solution, and the components were reacted at 85°C for 12 hours under the injection of the air, thereby obtaining an adhesive polymer 1 solution into which a polymerizable carbon-carbon double bond had been introduced.

To this solution, benzyl dimethyl ketal (manufactured by BASF, trade name: IRGACURE 651) (7 parts by mass) as the photoinitiator, an isocyanate-based crosslinking agent (manufactured by Mitsui Chemicals Inc., trade name: OLESTER P49-75S) (2 parts by mass), dipentaerythritol hexaacrylate (manufactured by Toagosei Co., Ltd., trade name: ARONIX M-400) (12 parts by mass) as a low-molecular-weight compound having two or more photopolymerizable carbon-carbon double bonds in a molecule, and the ionic additive 1: tetradecyl dimethyl benzyl ammonium chloride (manufactured by NOF Corporation, trade name: NISSAN CATION M₂-100) (0.5 parts by mass) with respect to 100 parts by mass (solid content) of a copolymer were added, thereby obtaining a coating fluid for an adhesive layer 1.

### <Coating Fluid for Adhesive Layer 2>

A coating fluid for an adhesive layer 2 was obtained in the same manner as for the coating fluid for an adhesive layer 1 except for the fact that the ionic additive 1 was not added.

### <Coating Fluid for Adhesive Layer 3>

Ethyl acrylate (48 parts by mass), 2-ethylhexyl acrylate (27 parts by mass), methyl acrylate (20 parts by mass), glycidyl methacrylate (5 parts by mass), and benzoyl peroxide (0.5 parts by mass) as a polymerization initiator were mixed together. The mixture was added dropwise to a nitrogen-substituted flask filled with toluene (65 parts by mass) and ethyl acetate (50 parts by mass) under stirring at 80°C for five hours, and, furthermore, the components were stirred for five hours and thus reacted. After the end of the reaction, this solution was cooled, xylene (25 parts by mass), acrylic acid (2.5parts by mass), and the ionic additive 1: tetradecyl dimethyl benzyl ammonium chloride (0.5 parts by mass) were added to the solution, and the components were reacted at 85°C for 32 hours under the injection of the air, thereby obtaining an adhesive polymer 3 solution into which a polymerizable carbon-carbon double bond had been introduced.

To this solution, benzyl dimethyl ketal (manufactured by BASF, trade name: IRGACURE 651) (7 parts by mass) as the photoinitiator, an isocyanate-based crosslinking agent (manufactured by Mitsui Chemicals Inc., trade name: OLESTER P49-75S) (2 parts by mass), and dipentaerythritol hexaacrylate (manufactured by Toagosei Co., Ltd., trade name: ARONIX M-400) (12 parts by mass) as a low-molecular-weight compound having two or more photopolymerizable carbon-carbon double bonds in a molecule with respect to 100 parts by mass (solid content) of a copolymer were added, thereby obtaining a coating fluid for an adhesive layer 3.

### [Example 1] (Reference Example, not according to the claimed invention)

An unevenness-absorbing resin 1 which served as the unevenness-absorbing resin layer was extrusion-laminated on a polyethylene terephthalate which served as the base material layer in a thickness of 195 µm, thereby obtaining a bilayer laminate film.

Next, the coating fluid for an adhesive layer 1 was applied and then dried on the unevenness-absorbing resin layer of the obtained laminate film, thereby forming a 10 um-thick adhesive layer and thus obtaining an adhesive film.

The following evaluations were carried out on the obtained adhesive film. The obtained results are shown in Table 1.

### [Example 2]

The unevenness-absorbing resin 1 which served as the unevenness-absorbing resin layer was extrusion-laminated on a polyethylene terephthalate which served as the base material layer in a thickness of 195 µm, thereby obtaining a bilayer laminate film.

Next, the material for forming an antistatic layer 1 was applied on separately prepared releasing film and then dried to form an antistatic film, and this antistatic film was laminated on the unevenness-absorbing resin layer, thereby forming a 0.1 um-thick antistatic layer.

Next, the coating fluid for an adhesive layer 2 was applied and then dried on the antistatic layer of the obtained laminate film, thereby forming a 10 um-thick adhesive layer and obtaining an adhesive film.

The following evaluations were carried out on the obtained adhesive film. The obtained results are shown in Table 1.

### [Example 3]

An unevenness-absorbing resin 1 which served as the unevenness-absorbing resin layer was extrusion-laminated on a polyethylene terephthalate which served as the base material layer in a thickness of 195 µm, thereby obtaining a bilayer laminate film.

Next, the material for forming an antistatic layer 1 was applied on separately prepared releasing film and then dried to form an antistatic film, and this antistatic film was laminated on the unevenness-absorbing resin layer, thereby forming a 0.1 um-thick antistatic layer.

Next, the coating fluid for an adhesive layer 1 was applied and then dried on the antistatic layer of the obtained laminate film, thereby forming a 10 um-thick adhesive layer and obtaining an adhesive film.

The following evaluations were carried out on the obtained adhesive film. The obtained results are shown in Table 1.

### [Example 4] (Reference Example, not according to the claimed invention)

An adhesive film was obtained in the same manner as in Example 3 except for the fact that the coating fluid for an adhesive layer 1 was changed to the coating fluid for an adhesive layer 3 and the thickness of the adhesive layer was set to 40 um.

The following evaluations were carried out on the obtained adhesive film. The obtained results are shown in Table 1.

### [Example 5] (Reference Example, not according to the claimed invention)

An adhesive film was obtained in the same manner as in Example 4 except for the fact that the coating fluid for an adhesive layer 3 was changed to the coating fluid for an adhesive layer 1.

The following evaluations were carried out on the obtained adhesive film. The obtained results are shown in Table 1.

### [Comparative Example 1]

An adhesive film was obtained in the same manner as in Example 1 except for the fact that the coating fluid for an adhesive layer 1 was changed to the coating fluid for an adhesive layer 2.

The following evaluations were carried out on the obtained adhesive film. The obtained results are shown in Table 1.

### [Comparative Example 2]

An adhesive film was obtained in the same manner as in Example 4 except for the fact that the antistatic layer was not formed.

The following evaluations were carried out on the obtained adhesive film. The obtained results are shown in Table 1.

### <Evaluations>

### (1) Measurement of Saturated Electrostatic Potential

Ultraviolet rays having a main wavelength of 365 nm were radiated to the adhesive resin layer in the adhesive film using a high-pressure mercury lamp (UVX-02528S1AJA02 manufactured by Ushio Inc.) in an environment of 25°C at a radiation intensity of 100 mW/cm² and an ultraviolet amount of 1,080 mJ/cm², thereby photocuring the adhesive resin layer. Next, using a static honestmeter H-0110-S4 manufactured by Shishido Electrostatic, Ltd. as a measurement instrument, a voltage was applied to a surface of the adhesive resin layer for 30 seconds under conditions of an applied voltage of 10 kV, a distance between a specimen and electrodes of 20 mm, 25°C, and 50%RH, and the saturated electrostatic potential (V₁) of the surface of the adhesive resin layer and the half-life of the saturated electrostatic potential V₁ were computed respectively according to JIS L1094.

The saturated electrostatic potential of the surface of the adhesive resin layer and the half-life of the saturated electrostatic potential were measured respectively in the same order as in the measurement of the saturated electrostatic potential (V₁) except for the fact that the ultraviolet amount was changed to 200 to 540 mJ/cm².

### (2) Measurement of Tack Force

Ultraviolet rays having a main wavelength of 365 nm were radiated to the adhesive resin layer in the adhesive film using a high-pressure mercury lamp in an environment of 25°C at a radiation intensity of 100 mW/cm² and an ultraviolet amount of 1,080 mJ/cm², thereby photocuring the adhesive resin layer. Next, the tack force of the surface of the adhesive resin layer was measured using a method in which, using a probe tack tester ("a probe tack tester manufactured by TESTING MACHINES Inc.: model 80-02-01") as a measurement instrument, a probe having a diameter of 5 mm and the surface of the adhesive resin layer were brought into contact with each other at a rate of 10 mm/second and held in contact with each other at a contact load of 0.98 N/cm² for 10 seconds, and then the probe was peeled off from the surface of the adhesive resin layer in the vertical direction at a rate of 10 mm/second.

The tack force of the surface of the adhesive resin layer was measured in the same order as in the measurement of the tack force except for the fact that the ultraviolet amount was changed to 200 to 360 mJ/cm².

### (3) Evaluation of Antistatic Property

The antistatic property of the adhesive film was evaluated using the following standards.

O: The saturated electrostatic potential V₁ was equal to or less than 2.0 kV, and the half-life of the saturated electrostatic potential V₁ was equal to or shorter than 100 seconds.

X: The saturated electrostatic potential V₁ was more than 2.0 kV, or the half-life of the saturated electrostatic potential V₁ was longer than 100 seconds.

(4) Evaluation of Adhesiveness to Semiconductor Wafer Surface The adhesiveness to the semiconductor wafer surface was evaluated using the following standards.

O: The tack force of the adhesive resin layer to which no ultraviolet rays were radiated (that is, the ultraviolet amount was 0 mJ/cm²) was equal to or more than 10 N/cm².

X: The tack force of the adhesive resin layer to which no ultraviolet rays were radiated was less than 10 N/cm².

### (5) Evaluation of Contamination Resistance on Semiconductor Wafer Surface

The contamination resistance on the semiconductor wafer surface was evaluated using the following standards.

O: The tack force of the adhesive resin layer photocured by the radiation with an ultraviolet amount of 1,080 mJ/cm² was equal to or less than 0.1 N/cm².

X: The tack force of the adhesive resin layer photocured by the radiation with an ultraviolet amount of 1,080 mJ/cm² was more than 0.1 N/cm².

**[Table 1]**

| | | Example 1* | Example 2 | Example 3 | Example 4* | Example 5* | Comparative Example 1 | Comparative Example 2 |
|---|---|---|---|---|---|---|---|---|
| Base material layer | Thickness [µm] | 50 | 50 | 50 | 50 | 50 | 50 | 50 |
| Unevenness-absorbing resin layer | Thickness [µm] | 195 | 195 | 195 | 195 | 195 | 195 | 195 |
| Antistatic layer | Presence or absence | Absent | Present | Present | Present | Present | Absent | Absent |
| | Thickness [µm] | - | 0.1 | 0.1 | 0.1 | 0.1 | - | - |
| Adhesive layer | Kind | Coating fluid 1 | Coating fluid 2 | Coating fluid 1 | Coating fluid 3 | Coating fluid 1 | Coating fluid 2 | Coating fluid 3 |
| | Presence or absence of ionic additive | Present | Absent | Present | Present | Present | Absent | Present |
| | Thickness [µm] | 10 | 10 | 10 | 40 | 40 | 10 | 40 |
| Saturated electrostatic potential [kV] | 0 mJ/cm² | 1.9 | 0.38 | 0.02 | 0.05 | 0.05 | 2.7 | 2.5 |
| | 200 mJ/cm² (V₂) | - | 1.1 | 0.14 | 0.24 | 0.38 | 2.6 | 2.5 |
| | 360 mJ/cm² | - | 1.2 | 0.21 | 0.41 | 0.42 | 2.6 | 2.5 |
| | 540 mJ/cm² | - | 1.3 | 0.25 | 0.43 | 0.53 | 2.6 | 2.5 |
| | 1,080 mJ/cm² (V₁) | 1.9 | 1.4 | 0.28 | 0.49 | 0.66 | 2.6 | 2.5 |
| Half-life of saturated electrostatic potential [seconds] | 0 mJ/cm² | 47 | 1.2 | <0.1 | <0.1 | <0.1 | >120 | >120 |
| | 200 mJ/cm² | - | 9.8 | 0.30 | 0.11 | 0.17 | >120 | >120 |
| | 360 mJ/cm² | - | 14.0 | 0.50 | 0.25 | 0.24 | >120 | >120 |
| | 540 mJ/cm² | - | 17.6 | 0.70 | 0.31 | 0.35 | >120 | >120 |
| | 1,080 mJ/cm² | 51 | 21.5 | 0.60 | 0.39 | 0.50 | >120 | >120 |
| Tack force [N/cm²] | 0 mJ/cm² | 22.5 | 22.5 | 22.5 | 17.5 | 22.5 | 22.5 | 17.5 |
| | 200 mJ/cm² | 2.1 | 2.1 | 2.1 | 1.7 | 2.1 | 2.1 | 1.7 |
| | 360 mJ/cm² | 0.6 | 0.6 | 0.6 | 0.2 | 0.6 | 0.6 | 0.2 |
| | 1,080 mJ/cm² | 0 | 0 | 0 | 0 | 0 | 0 | 0 |
| Evaluation results | Antistatic property | ○ | ○ | ○ | ○ | ○ | X | X |
| | Adhesiveness | ○ | ○ | ○ | ○ | ○ | ○ | ○ |
| | Contamination resistance | ○ | ○ | ○ | ○ | ○ | ○ | ○ |

| | | | | | | | | |
|---|---|---|---|---|---|---|---|---|
| *Reference Example, not according to the claimed invention. | | | | | | | | |

The adhesive films of Examples 1 to 5 in which the saturated electrostatic potential V₁ of the adhesive resin layer surface after ultraviolet curing was equal to or less than 2.0 kV were excellent in terms of the balance between the adhesiveness and the contamination resistance on the semiconductor wafer surface and also excellent in terms of the antistatic property. That is, it can be understood that, according to the adhesive film for processing a semiconductor wafer 100, it is possible to suppress the amount of static electricity being generated when the adhesive film is peeled off from the semiconductor wafer and semiconductor components having an excellent quality can be stably obtained.

In contrast, the adhesive films of Comparative Examples 1 and 2 in which the saturated electrostatic potential V₁ of the adhesive resin layer surface after ultraviolet curing was more than 2.0 kV were excellent in terms of the balance between the adhesiveness and the contamination resistance on the semiconductor wafer surface, but was poor in terms of the antistatic property.

## Claims

1. An adhesive film for processing a semiconductor wafer and for protecting a surface of a semiconductor wafer or fixing the semiconductor wafer comprising: a base material layer and an ultraviolet-curable adhesive resin layer provided on one surface side of the base material layer,
wherein the adhesive resin layer includes an ultraviolet-curable adhesive resin,
wherein a saturated electrostatic potential V₁ of the adhesive resin layer surface after ultraviolet curing, which is measured using a method described below, is equal to or less than 2.0 kV,
(method)
ultraviolet rays having a main wavelength of 365 nm are radiated to the adhesive resin layer using a high-pressure mercury lamp in an environment of 25°C at a radiation intensity of 100 mW/cm² and an ultraviolet amount of 1,080 mJ/cm², thereby photocuring the adhesive resin layer, and then a voltage is applied to a surface of the adhesive resin layer for 30 seconds under conditions of an applied voltage of 10 kV, a distance between a specimen and electrodes of 20 mm, 25°C, and 50%RH, and the saturated electrostatic potential (V₁) of the surface of the adhesive resin layer is computed according to JIS L1094,
wherein the adhesive resin layer has an antistatic layer and an adhesive layer in this order from the base material layer side,
wherein the adhesive resin layer further has an unevenness-absorbing resin layer between the base material layer and the antistatic layer, and a thickness of the adhesive layer is less than 30 um,
wherein the ultraviolet-curable adhesive resin includes a (meth)acrylic adhesive resin having a photopolymerizable carbon-carbon double bond in a molecule, and
wherein the resin constituting the unevenness-absorbing resin layer includes one, two or more selected from the group consisting of olefin-based resins, ethylene·polar monomer copolymers, ABS resins, vinyl chloride resins, vinylidene chloride resins, (meth)acrylic resins, polyamide resins, and fluorine-based resins.

2. The adhesive film for processing a semiconductor wafer according to Claim 1,
wherein a tack force of the surface of the adhesive resin layer after ultraviolet curing, which is measured using a method described below, is equal to or less than 0.1 N/cm²,
(method)
ultraviolet rays having a main wavelength of 365 nm are radiated to the adhesive resin layer using a high-pressure mercury lamp in an environment of 25°C at a radiation intensity of 100 mW/cm² and an ultraviolet amount of 1,080 mJ/cm², thereby photocuring the adhesive resin layer, and then the tack force of the surface of the adhesive resin layer is measured using a method in which, using a probe tack tester as a measurement instrument, a probe having a diameter of 5 mm and the surface of the adhesive resin layer are brought into contact with each other at a rate of 10 mm/second and held in contact with each other at a contact load of 0.98 N/cm² for 10 seconds, and then the probe is peeled off from the surface of the adhesive resin layer in a vertical direction at a rate of 10 mm/second.

3. The adhesive film for processing a semiconductor wafer according to Claim 1 or 2,
wherein, when a saturated electrostatic potential of the surface of the adhesive resin layer after ultraviolet curing, which is measured using a method described below, is represented by V₂, V₁/V₂ is equal to or less than 5.0,
(method)
ultraviolet rays having a main wavelength of 365 nm are radiated to the adhesive resin layer using a high-pressure mercury lamp in an environment of 25°C at a radiation intensity of 100 mW/cm² and an ultraviolet amount of 200 mJ/cm², thereby photocuring the adhesive resin layer, and then a voltage is applied to the surface of the adhesive resin layer for 30 seconds under conditions of an applied voltage of 10 kV, a distance between a specimen and electrodes of 20 mm, 25°C, and 50%RH, and the saturated electrostatic potential (V₂) of the surface of the adhesive resin layer is computed according to JIS L1094.

4. The adhesive film for processing a semiconductor wafer according to any one of Claims 1 to 3,
wherein a half-life of the saturated electrostatic potential V₁ is equal to or shorter than 100 seconds.

5. The adhesive film for processing a semiconductor wafer according to any one of Claims 1 to 4,
wherein a thickness of the adhesive resin layer is equal to or more than 5 um and equal to or less than 550 µm.

6. The adhesive film for processing a semiconductor wafer according to any one of Claims 1 to 5,
wherein the antistatic layer includes a conductive polymer.

7. The adhesive film for processing a semiconductor wafer according to any one of Claims 1 to 6,
wherein the adhesive layer includes an ultraviolet-curable adhesive resin and an ionic additive.

8. The adhesive film for processing a semiconductor wafer according to any one of Claims 1 to 7,
wherein a thickness of the antistatic layer is equal to or more than 0.01 um and equal to or less than 10 µm.

9. Use of the adhesive film according to any one of Claims 1 to 8 as a back grinding tape for processing a semiconductor wafer.

10. The use of the adhesive film according to Claim 9,
wherein a bump electrode is formed on the surface of the semiconductor wafer.

## Patentansprüche

1. Klebefilm zur Bearbeitung eines Halbleiterwafers und zum Schutz einer Oberfläche eines Halbleiterwafers oder zur Fixierung des Halbleiterwafers, umfassend: eine Basismaterialschicht und eine UV-härtbare Klebharzschicht, die auf einer Oberflächenseite der Basismaterialschicht angeordnet ist,
wobei die Klebharzschicht ein UV-härtbares Klebeharz enthält,
wobei ein gesättigtes elektrostatisches Potential V₁ der Oberfläche der Klebharzschicht nach UV-Härtung, das unter Verwendung einer unten beschriebenen Methode gemessen wird, gleich oder weniger als 2,0 kV ist,
(Methode)
UV-Strahlen mit einer Hauptwellenlänge von 365 nm werden unter Verwendung einer Quecksilberhochdrucklampe in einer Umgebung von 25°C mit einer Strahlungsintensität von 100 mW/cm² und einer UV-Menge von 1.080 mJ/cm² auf die Klebharzschicht gestrahlt, wodurch die Klebharzschicht photogehärtet wird, und dann wird eine Spannung an eine Oberfläche der Klebharzschicht für 30 Sekunden unter den Bedingungen von einer angelegten Spannung von 10 kV, einem Abstand zwischen einer Probe und Elektroden von 20 mm, 25°C und 50% relativer Luftfeuchtigkeit angelegt und das gesättigte elektrostatische Potential (V₁) der Oberfläche der Klebharzschicht wird gemäß JIS L1094 berechnet,
wobei die Klebharzschicht eine antistatische Schicht und eine Klebeschicht in dieser Reihenfolge von der Seite der Basismaterialschicht her aufweist,
wobei die Klebharzschicht ferner eine Unebenheiten absorbierende Harzschicht zwischen der Basismaterialschicht und der antistatischen Schicht aufweist und eine Dicke der Klebeschicht weniger als 30 µm beträgt,
wobei das UV-härtbare Klebeharz ein (Meth)acryl-Klebeharz mit einer photopolymerisierbaren Kohlenstoff-Kohlenstoff-Doppelbindung in einem Molekül enthält, und
wobei das Harz, das die Unebenheiten absorbierende Harzschicht bildet, eines, zwei oder mehrere umfasst, die aus der Gruppe ausgewählt sind, die aus olefinbasierten Harzen, Ethylen-polares Monomer-Copolymeren, ABS-Harzen, Vinylchloridharzen, Vinylidenchloridharzen, (Meth)acrylharzen, Polyamidharzen und fluorbasierten Harzen besteht.

2. Klebefilm zur Bearbeitung eines Halbleiterwafers gemäß Anspruch 1,
wobei eine Klebekraft der Oberfläche der Klebharzschicht nach UV-Härtung, die unter Verwendung einer unten beschriebenen Methode gemessen wird, gleich oder kleiner als 0,1 N/cm² ist,
(Methode)
UV-Strahlen mit einer Hauptwellenlänge von 365 nm werden unter Verwendung einer Quecksilberhochdrucklampe in einer Umgebung von 25°C mit einer Strahlungsintensität von 100 mW/cm² und einer UV-Menge von 1.080 mJ/cm² auf die Klebharzschicht gestrahlt, wodurch die Klebharzschicht photogehärtet wird, und dann wird die Klebekraft der Oberfläche der Klebharzschicht unter Verwendung einer Methode gemessen, bei der unter Verwendung eines Sonden-Klebkrafttesters als Messinstrument eine Sonde mit einem Durchmesser von 5 mm und die Oberfläche der Klebharzschicht mit einer Geschwindigkeit von 10 mm/Sekunde miteinander in Kontakt gebracht und mit einer Kontaktlast von 0,98 N/cm² 10 Sekunden lang in Kontakt gehalten werden, und die Sonde dann mit einer Geschwindigkeit von 10 mm/Sekunde in vertikaler Richtung von der Oberfläche der Klebeschicht abgezogen wird.

3. Klebefilm zur Bearbeitung eines Halbleiterwafers gemäß Anspruch 1 oder 2,
wobei, wenn ein gesättigtes elektrostatisches Potential der Oberfläche der Klebharzschicht nach UV-Härtung, das unter Verwendung einer unten beschriebenen Methode gemessen wird, durch V₂ dargestellt wird, V₁/V₂ gleich oder kleiner als 5,0 ist,
(Methode)
UV-Strahlen mit einer Hauptwellenlänge von 365 nm werden unter Verwendung einer Quecksilberhochdrucklampe in einer Umgebung von 25°C mit einer Strahlungsintensität von 100 mW/cm² und einer UV-Menge von 200 mJ/cm² auf die Klebharzschicht gestrahlt, wodurch die Klebharzschicht photogehärtet wird, und dann wird eine Spannung an die Oberfläche der Klebharzschicht für 30 Sekunden unter Bedingungen von einer angelegten Spannung von 10 kV, einem Abstand zwischen einer Probe und Elektroden von 20 mm, 25°C und 50% relativer Luftfeuchtigkeit angelegt, und das gesättigte elektrostatische Potential (V₂) der Oberfläche der Klebharzschicht wird gemäß JIS L1094 berechnet.

4. Klebefilm zur Bearbeitung eines Halbleiterwafers gemäß einem der Ansprüche 1 bis 3,
wobei eine Halbwertszeit des gesättigten elektrostatischen Potentials V₁ gleich oder kürzer als 100 Sekunden ist.

5. Klebefilm zur Bearbeitung eines Halbleiterwafers gemäß einem der Ansprüche 1 bis 4,
wobei eine Dicke der Klebharzschicht gleich oder größer als 5 µm und gleich oder kleiner als 550 µm ist.

6. Klebefilm zur Bearbeitung eines Halbleiterwafers gemäß einem der Ansprüche 1 bis 5,
wobei die antistatische Schicht ein leitfähiges Polymer enthält.

7. Klebefilm zur Bearbeitung eines Halbleiterwafers gemäß einem der Ansprüche 1 bis 6,
wobei die Klebeschicht ein UV-härtbares Klebeharz und ein ionisches Additiv enthält.

8. Klebefilm zur Bearbeitung eines Halbleiterwafers gemäß einem der Ansprüche 1 bis 7,
wobei eine Dicke der antistatischen Schicht gleich oder mehr als 0,01 µm und gleich oder weniger als 10 µm ist.

9. Verwendung des Klebefilms gemäß einem der Ansprüche 1 bis 8 als Rückseitenschleifband für die Bearbeitung eines Halbleiterwafers.

10. Verwendung des Klebefilms gemäß Anspruch 9,
wobei auf der Oberfläche des Halbleiterwafers eine Höckerelektrode gebildet ist.

## Revendications

1. Film adhésif pour traiter une tranche de semi-conducteur et pour protéger une surface d'une tranche de semi-conducteur ou fixer la tranche de semi-conducteur, comprenant : une couche de matériau de base et une couche de résine adhésive durcissable par ultraviolets disposée sur un côté surface de la couche de matériau de base,
dans lequel la couche de résine adhésive inclut une résine adhésive durcissable par ultraviolets,
dans lequel un potentiel électrostatique saturé V₁ de la surface de couche de résine adhésive après durcissement par ultraviolets, qui est mesuré en utilisant un procédé décrit ci-dessous, est égal ou inférieur à 2,0 kV,
(procédé)
des rayons ultraviolets présentant une longueur d'onde principale de 365 nm sont émis vers la couche de résine adhésive en utilisant une lampe au mercure haute-pression dans un environnement de 25 °C à une intensité de rayonnement de 100 mW/cm² et une quantité d'ultraviolets de 1080 mJ/cm², photodurcissant ainsi la couche de résine adhésive, et ensuite une tension est appliquée à une surface de la couche de résine adhésive pendant 30 secondes dans des conditions d'une tension appliquée de 10 kV, d'une distance entre un échantillon et des électrodes de 20 mm, 25 °C et 50 % HR, et le potentiel électrostatique saturé (V₁) de la surface de la couche de résine adhésive est calculé selon la norme JIS L1094,
dans lequel la couche de résine adhésive présente une couche antistatique et une couche adhésive dans cet ordre depuis le côté couche de matériau de base,
dans lequel la couche de résine adhésive présente en outre une couche de résine d'absorption d'irrégularités entre la couche de matériau de base et la couche antistatique, et une épaisseur de la couche adhésive est moins de 30 µm,
dans lequel la résine adhésive durcissable par ultraviolets inclut une résine adhésive (méth)acrylique présentant une double liaison carbone-carbone photopolymérisable dans une molécule, et
dans lequel la résine constituant la couche de résine d'absorption d'irrégularités inclut un, deux ou plus sélectionnés à partir du groupe consistant en résines à base d'oléfine, copolymères d'éthylène·monomère polaire, résines ABS, résine de chlorure de vinyle, résines de chlorure de vinylidène, résines (méth)acryliques, résines polyamides et résines à base de fluor.

2. Film adhésif pour traiter une tranche de semi-conducteur selon la revendication 1,
dans lequel une force d'adhérence de la surface de couche de résine adhésive après durcissement par ultraviolets, qui est mesurée en utilisant un procédé décrit ci-dessous, est égale ou inférieure à 0,1 N/cm²,
(procédé)
des rayons ultraviolets présentant une longueur d'onde principale de 365 nm sont émis vers la couche de résine adhésive en utilisant une lampe au mercure haute-pression dans un environnement de 25 °C à une intensité de rayonnement de 100 mW/cm² et une quantité d'ultraviolets de 1080 mJ/cm², photodurcissant ainsi la couche de résine adhésive, et ensuite la force d'adhérence de la surface de la couche de résine adhésive est mesurée en utilisant un procédé dans lequel, en utilisant un testeur de force d'adhérence à sonde comme instrument de mesure, une sonde présentant un diamètre de 5 mm et la surface de la couche de résine adhésive sont amenées en contact l'une avec l'autre à une vitesse de 10 mm/seconde et maintenues en contact l'une avec l'autre à une charge de contact de 0,98 N/cm² pendant 10 secondes, puis la sonde est détachée de la surface de la couche de résine adhésive dans une direction verticale à une vitesse de 10 mm/seconde.

3. Film adhésif pour traiter une tranche de semi-conducteur selon la revendication 1 ou la revendication 2,
dans lequel, lorsqu'un potentiel électrostatique saturé de la surface de la couche de résine adhésive après durcissement par ultraviolets, qui est mesuré en utilisant un procédé décrit ci-dessous, est représenté par V₂, V₁/V₂ est égal ou inférieur à 5,0,
(procédé)
des rayons ultraviolets présentant une longueur d'onde principale de 365 nm sont émis vers la couche de résine adhésive en utilisant une lampe au mercure haute-pression dans un environnement de 25 °C à une intensité de rayonnement de 100 mW/cm² et une quantité d'ultraviolets de 200 mJ/cm², photodurcissant ainsi la couche de résine adhésive, et ensuite une tension est appliquée à la surface de la couche de résine adhésive pendant 30 secondes dans des conditions d'une tension appliquée de 10 kV, d'une distance entre un échantillon et des électrodes de 20 mm, 25 °C et 50 % HR, et le potentiel électrostatique saturé (V₂) de la surface de la couche de résine adhésive est calculé selon la norme JIS L1094.

4. Film adhésif pour traiter une tranche de semi-conducteur selon l'une quelconque des revendications 1 à 3,
dans lequel une demi-vie du potentiel électrostatique saturé V₁ est égale ou inférieure à 100 secondes.

5. Film adhésif pour traiter une tranche de semi-conducteur selon l'une quelconque des revendications 1 à 4,
dans lequel une épaisseur de la couche de résine adhésive est égale ou supérieure à 5 µm et égale ou inférieure à 550 µm.

6. Film adhésif pour traiter une tranche de semi-conducteur selon l'une quelconque des revendications 1 à 5,
dans lequel la couche antistatique inclut un polymère conducteur.

7. Film adhésif pour traiter une tranche de semi-conducteur selon l'une quelconque des revendications 1 à 6,
dans lequel la couche adhésive inclut une résine adhésive durcissable par ultraviolets et un additif ionique.

8. Film adhésif pour traiter une tranche de semi-conducteur selon l'une quelconque des revendications 1 à 7,
dans lequel une épaisseur de la couche antistatique est égale ou supérieure à 0,01 µm et égale ou inférieure à 10 µm.

9. Utilisation du film adhésif selon l'une quelconque des revendications 1 à 8 en tant que bande de meulage arrière pour traiter une tranche de semi-conducteur.

10. Utilisation du film adhésif selon la revendication 9,
dans laquelle une électrode à bosse est formée sur la surface de la tranche de semi-conducteur.
